# EUROPEAN PATENT SPECIFICATION

(11) **EP 3 334 264 B1**
(45) Date of publication and mention of the grant of the patent: **14.10.2020**
(21) Application number: 15900409.2
(22) Date of filing: 05.08.2015
(51) Int. Cl.: H05K 13/02, H05K 13/04, H05K 13/08

(54) **COMPONENT MOUNTING APPARATUS**
KOMPONENTENMONTAGEVORRICHTUNG
APPAREIL DE MONTAGE DE COMPOSANTS

(43) Date of publication of application: 13.06.2018
(73) Proprietor: FUJI Corporation, Chiryu Aichi (JP)
(72) Inventor: IISAKA, Jun, Chiryu Aichi (JP); ITO, Hidetoshi, Chiryu Aichi (JP); TANAKA, Keita, Chiryu Aichi (JP)
(74) Representative: Grünecker Patent- und Rechtsanwälte PartG mbB
(86) International application number: PCT/JP2015/072235
(87) International publication number: WO 2017/022098

(56) References cited:
- WO-A1-2013/140520
- WO-A1-2016/157287
- JP-A- H03 256 662
- JP-A- H10 163 699
- JP-A- H10 163 699
- JP-A- S61 264 789
- JP-A- S61 264 789
- US-A- 6 157 870
- US-A1- 2003 219 330

## Description

### Technical Field

The present invention relates to a component mounting machine including a feeder device for feeding carrier tapes and sequentially supplying components.

### Background Art

As facilities for producing boards on which a large number of components are mounted, there are solder printing machines, component mounting machines, reflow machines, board inspection machines, or the like. It is common to connect these facilities to constitute a board production line. Among facilities described above, the component mounting machine includes a board conveyance device, a component supply device, a component transfer device, and a control device. As a typical example of a component supply device, there is a feeder device that feeds a carrier tape formed by aligning cavity sections for holding components in a row and sequentially supplies the components to predetermined supply positions. The component transfer device includes a suction nozzle which suctions a component from the cavity section and mounts the component on a board, and a mounting head which holds the suction nozzle. In order to efficiently mount small-sized components such as chip components, a rotary nozzle unit which rotatably holds multiple suction nozzles is used. Technical examples relating to this kind of component mounting machine are disclosed in PTL 1 and PTL 2.

The tape feeder (feeder device) of PTL 1 includes a component removal opening section provided in a cover member covering above the carrier tape and a component confirmation opening section which is provided on an upstream side of the component removal opening section of the cover member and confirms the presence or absence of an electronic component. According to this, it is said that it is possible to confirm the presence or absence of the electronic component in a recessed section (cavity section) when the tape is mounted, to prevent oversight of the electronic component, and to eliminate a wasteful operation of the electronic component. Supplementally, in general, several cavity sections near a leading end and near a tail end of the carrier tape do not hold the electronic component and the position of the cavity section holding the first electronic component is undefined. According to the technique of PTL 1, since the first electronic component can be confirmed from the component confirmation opening section in a heading operation of the carrier tape by an operator, a wasteful operation of passing the electronic component through the component removal opening section by the oversight of the electronic component is not generated.

In addition, the electronic component mounting method of PTL 2 is a method in which three or more suction nozzles are provided in a transfer head (mounting head) and at the same time electronic components are picked up (suctioned) and the presence or absence of a pickup mistake is detected, in a case where there is a pickup mistake, the suction nozzle which makes the mistake is accurately moved to the pickup position and the pickup is performed again. According to this, it is said that it is possible to solve the pickup mistake caused by the installation pitch error of the pickup position having three or more locations.
PTL 3 and PTL 4 disclose the preamble of claim 1.

### Citation List

### Patent Literature

PTL 1: JP-A-2003-298288
PTL 2: JP-A-10-107491
PTL 3: US 6 157 870 A
PTL 4: US 2003/219330 A1

### Summary of Invention

### Technical Problem

Accurately managing the remaining number of components held by the carrier tape is not easy for the control device in the component mounting machine. For example, there is a case where some components are actually held more than the nominal number of components held on a new carrier tape. In addition, in a case where in-use carrier tapes are used, in a case where a carrier tape is manually fed when the carrier tape is loaded in the feeder device or the like, the remaining number of components at that point in time becomes unknown and the management of the remaining number of the component is not performed by the control device.

Therefore, it is not limited to the techniques of PTL 1 and PTL 2 but the suction operation of the suction nozzle is generally performed also on the cavity section which is positioned near the tail end of the carrier tape and does not hold the component. In this case, of course, it is impossible to suction the components, resulting in an invalid suction operation. To make a determination whether or not the suction operation is invalid, for example, it is necessary to image the component suction state of the suction nozzle and further perform an image processing. Accordingly, the production efficiency of the board is reduced by the amount of invalid suction operation and determination processing as to whether or not it is invalid. In addition, since the suction nozzle suctions more outside air than usual by the invalid suction operation, there is a concern that a negative pressure state of the negative pressure supply mechanism may decrease.

The invention has been made in view of the above problems of the background art and an object thereof is to provide a component mounting machine which is positioned near a tail end of a carrier tape and can improve production efficiency of a board by an invalid suction operation being not performed on a cavity section which does not hold the component.

### Solution to Problem

According to the invention for solving the problems described above, there is provided a component mounting machine including: a component supply section which has a feeder device for feeding carrier tapes formed by cavity sections for holding components being aligned in a row and is configured to sequentially supply the components to a predetermined supply position; a component transfer device which has a suction nozzle configured to suck the components from the cavity sections at the supply position and mount the component on a board, a mounting head configured to hold the suction nozzle, and a head driving mechanism configured to drive the suction nozzle and the mounting head; a component fewness detecting section configured to detect that a remaining number of components held by the carrier tape decreases to a predetermined small number; and an invalid suction avoidance section configured to avoid an invalid suction operation of the suction nozzle based on a detection result of the component fewness detecting section when the remaining number of components held by the carrier tape reaches zero, wherein the component supply section has a plurality of feeder devices, and wherein the component fewness detecting section is provided on the mounting head, is shared by a plurality of feeder devices, and faces a tail end side cavity section formed on a tail end side of the carrier tape more by the small number than the cavity section at the supply position in conjunction with the suction nozzle being driven to the supply position of any one of the plurality of feeder devices and is configured to detect that whether or not the component is held on the tail end side cavity section.

### Advantageous Effects of Invention

According to the component mounting machine of the invention, since the component fewness detecting section detects that the remaining number of the components held by the carrier tape decreases to a predetermined small number, it can be known accurately when the remaining number of components becomes zero based on a detection result. The invalid suction avoidance section avoids an invalid suction operation of the suction nozzle when the remaining number of components becomes zero. Therefore, since the invalid suction operation is not performed with respect to the cavity section that does not hold the component and the invalid suction operation and a determination process as to whether or not it is invalid are not performed, production efficiency of the board is higher than that of the related art.

### Brief Description of Drawings

[Fig. 1] Fig. 1 is a plan view schematically illustrating a configuration of a component mounting machine according to a first embodiment.
[Fig. 2] Fig. 2 is a block diagram illustrating a control configuration of a component mounting machine according to the first embodiment.
[Fig. 3] Fig. 3 is a perspective view illustrating a state where a mounting head is driven above the supply position of a feeder device.
[Fig. 4] Fig. 4 is a side sectional view illustrating a cross-section of a feeder device and a mounting head and a first light path and a second light path of the camera device.
[Fig. 5] Fig. 5 is a plan view schematically explaining an operation of the component mounting machine according to the first embodiment.
[Fig. 6] Fig. 6 is a plan view illustrating a state where one component is suctioned from a state of Fig. 5 and thus the remaining number of components is reduced to a predetermined small number.
[Fig. 7] Fig. 7 is a plan view illustrating a state where the suction nozzle suctions the last component after two components are suctioned from a state of Fig. 6.
[Fig. 8] Fig. 8 is a plan view schematically explaining a configuration and an operation of a component mounting machine according to the related art.
[Fig. 9] Fig. 9 is a plan view explaining a method of detecting that the remaining number of components becomes zero in the related art.
[Fig. 10] Fig. 10 is a plan view schematically illustrating a configuration of a component mounting machine according to a second embodiment.
[Fig. 11] Fig. 11 is a perspective view illustrating a first light path and a second light path of the camera device of the second embodiment.
[Fig. 12] Fig. 12 is a plan view for schematically explaining the operation of the component mounting machine according to the second embodiment.
[Fig. 13] Fig. 13 is a plan view illustrating a state where the eighth suction nozzle suctions the last component of the component type B after two components of component types A and B are suctioned from a state of Fig. 12.

### Description of Embodiments

### (1. Configuration of component mounting machine 1 according to first embodiment)

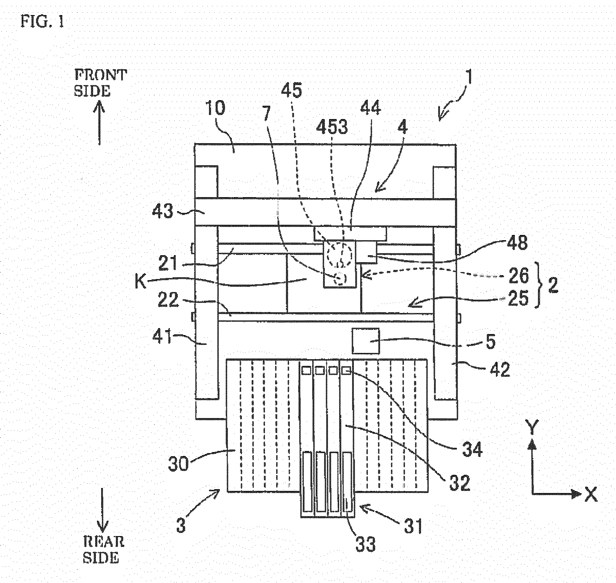

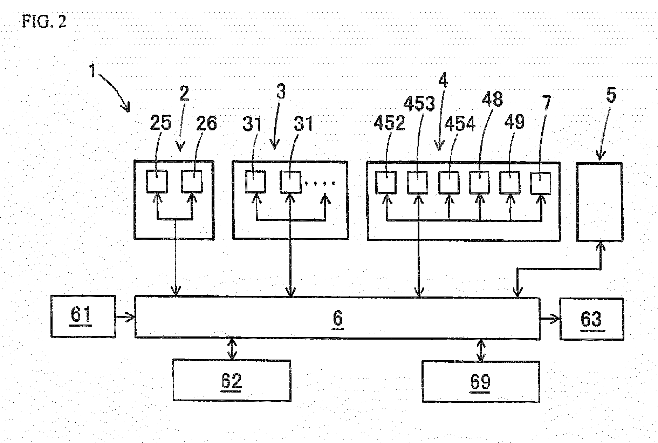

A component mounting machine 1 according to a first embodiment of the invention will be described with reference to Fig. 1 to Fig. 7. Fig. 1 is a plan view schematically illustrating the configuration of the component mounting machine 1 according to the first embodiment. The direction from the left side toward the right side of the page of Fig. 1 is the X-axis direction in which the board K is introduced and discharged, the direction from the rear side on the lower side of the page toward the front side on the upper side of the page is the Y-axis direction, the front and back direction of the page is the Z-axis direction (up-down direction). The component mounting machine 1 is configured by assembling a board conveyance device 2, a component supply section 3, a component transfer device 4, a component camera 5, a control device 6 (illustrated in Fig. 2), and the like to the device table 10. Fig. 2 is a block diagram illustrating a control configuration of the component mounting machine 1 according to the first embodiment. The board conveyance device 2, the component supply section 3, the component transfer device 4, and the component camera 5 are controlled from the control device 6 and each performs a predetermined operation.

The board conveyance device 2 introduces the board K to the mounting execution position, positions and discharges the board K. The board conveyance device 2 includes a conveyance unit 25 and a backup unit 26. The conveyance unit 25 includes a pair of guide rails 21 and 22 and a pair of conveyor belts and the like. The pair of guide rails 21 and 22 extends in a conveyance direction (X-axis direction) at a center of an upper face of the device table 10 and is disposed in parallel to each other. A pair of endless annular conveyor belts (not illustrated) is arranged on an inside of the pair of guide rails 21 and 22 facing each other in parallel. The pair of conveyor belts rotates in a state where both edges of the board K are mounted, respectively, so as to introduce and discharge the board K to and from the mounting execution position set in the central section of the device table 10. The backup unit 26 is disposed below the mounting execution position. The backup unit 26 pushes up the board K and clamps the board K in a horizontal posture and positions the board K at the mounting execution position. Accordingly, the component transfer device 4 can perform the component mounting operation at the mounting execution position.

The component supply section 3 includes a pallet table 30, multiple feeder devices 31, and the like. The pallet table 30 has a substantially rectangular plate shape and is detachably equipped near the rear side of the upper face of the device table 10. The feeder device 31 is formed thin in the width direction dimension and is equipped on the pallet table 30 in parallel. In Fig. 1, four feeder devices 31 are illustrated, and in practice, a larger number of feeder devices 31 are arranged in rows.

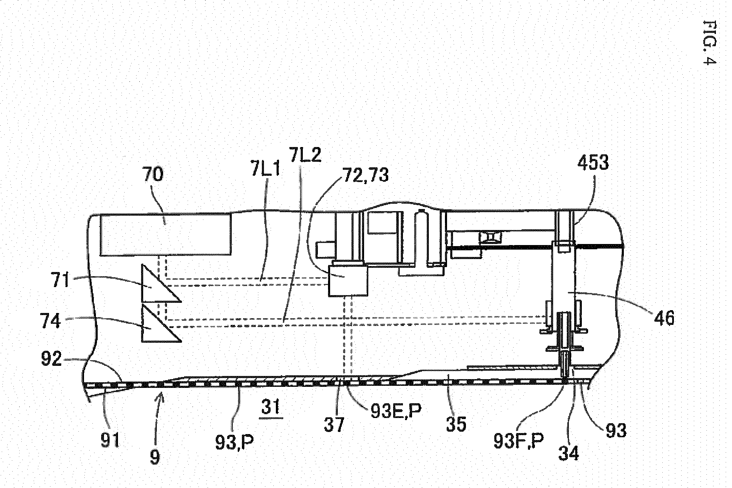

The feeder device 31 includes a main body section 32, a tape reel 33 which is exchangeably set in the rear section of the main body section 32, and the like. A supply position 34 is set at the upper section in the vicinity of a front end of the main body section 32. On the tape reel 33, a carrier tape 9 (illustrated in Fig. 4) is wound and held. The carrier tape 9 includes a bottom tape 91 in which cavity sections 93 for holding components are formed with a fixed pitch and a cover tape 92 which is attached to the bottom tape 91 and covers the cavity section 93. The bottom tape 91 is made of paper or resin and the cover tape 92 is made of a transparent film or the like. The feeder device 31 feeds the carrier tape 9 at a fixed pitch and sequentially supplies the components to the supply position 34. According to the type of board K to be produced, the multiple feeder devices 31 are exchanged as appropriate or the entire component supply section 3 is exchanged.

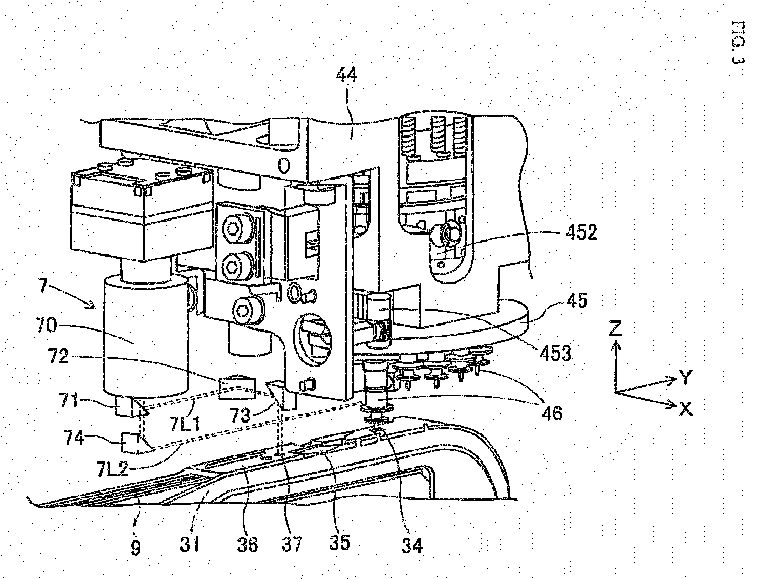

The component transfer device 4 is an XY-robot type device that can horizontally move in the X-axis direction and the Y-axis direction. The component transfer device 4 includes a pair of Y-axis rails 41 and 42 and a Y-axis slider 43 which constitute a head driving mechanism 49, a mounting head 44, a rotary nozzle unit 45, a suction nozzle 46 (illustrated in Fig. 3), a camera device 7, a board camera 48, and the like. The pair of Y-axis rails 41 and 42 are disposed near both side faces of the device table 10 and extend in the front-rear direction (Y-axis direction). A Y-axis slider 43 is movably mounted on the Y-axis rails 41 and 42. The Y-axis slider 43 is driven in the Y-axis direction by a Y-axis ball screw mechanism (not illustrated).

The mounting head 44 is movably mounted on the Y-axis slider 43. The mounting head 44 is driven in the X-axis direction by an X-axis ball screw mechanism (not illustrated). The rotary nozzle unit 45 is exchangeably held below the mounting head 44. The rotary nozzle unit 45 holds 16 suction nozzles 46 downward. The camera device 7 is provided in the mounting head 44 in parallel at the rear of the rotary nozzle unit 45. The camera device 7 corresponds to the component fewness detecting section of the invention. The rotary nozzle unit 45 and the camera device 7 will be described below in detail. The board camera 48 is provided on the mounting head 44 in parallel in the side of the rotary nozzle unit 45. The board camera 48 images the position fiducial marks attached to the board K and detects the exact position of the board K.

The component camera 5 is provided upward on the upper face of the device table 10 between the board conveyance device 2 and the component supply section 3. While the mounting head 44 is moving from the component supply section 3 onto the board K, the component camera 5 images a state of the component suctioned by the suction nozzle 46. When an error in the suction posture of the component, a deviation in the rotation angle or the like are found from the captured image data of the component camera 5, the control device 6 performs control that finely adjusts the component mounting operation as necessary and discards the component in a case where the component is unlikely to be mounted.

The control device 6 is assembled to the device table 10 and an installation position thereof is not particularly limited. The control device 6 is a computer device having a CPU and operating with software. The control device 6 includes an input section 61 which performs input setting by an operator, a display section 63 which displays information to an operator, and a memory section 62 which stores various programs and data. As illustrated in Fig. 2, the control device 6 is communicatively connected to the board conveyance device 2, each feeder device 31 of the component supply section 3, the component transfer device 4, and the component camera 5. Further, the control device 6 is also communicatively connected to the higher-level host computer 69.

The control device 6 holds a mounting sequence designating the kind and the mounting order of components to be mounted on the board K, the feeder device 31 for supplying the components, and the like. The control device 6 controls the component mounting operation according to the mounting sequence based on the captured image data of the camera device 7, the board camera 48, and the component camera 5, the detection data of a sensor (not illustrated), and the like. In addition, the control device 6 sequentially collects and updates the operation condition data such as the production number of production completed board K, the mounting time required for mounting the components, the number of generation of the component suction error, and the like. Further, as will be described below, the control device 6 performs the functions of the invalid suction avoidance section and a component shortage coping section of the invention.

### (2. Detailed configuration of feeder device 31 and mounting head 44)

Fig. 3 is a perspective view illustrating a state where the mounting head 44 is driven above the supply position 34 of the feeder device 31. As illustrated in the drawing, a tape peeling section 35 is disposed behind the supply position 34 of the feeder device 31. The tape peeling section 35 peels off the cover tape 92 from the bottom tape 91, opens the cavity section 93, and makes it possible to suction components. The tape peeling section 35 is configured to peel one of the two adhesive locations and fold the cover tape 92 to the other side of the adhesion location. The invention is not limited thereto and the tape peeling section may be configured so that both sides of the two adhesive locations of the cover tape 92 are peeled off and separated from the bottom tape 91.

A retaining plate 36 is disposed behind the tape peeling section 35. The retaining plate 36 is arranged in parallel to the upper side of a rail member (not illustrated) for guiding the feeding of the carrier tape 9 white being spaced apart from each other. The retaining plate 36 reduces floating of the carrier tape 9. A component confirmation hole 37 is drilled near the front side of the retaining plate 36. The component confirmation hole 37 is for imaging or visually confirming the carrier tape 9 and confirming the presence or absence of a component in the cavity section 93.

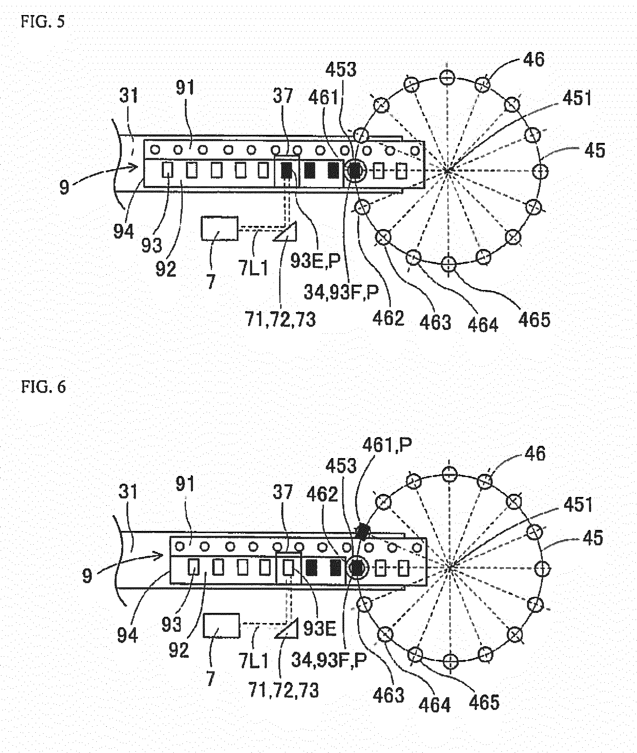

The rotary nozzle unit 45 has an R-axis rotation driving mechanism 452 that rotatably drives the sixteen suction nozzles 46 about the central axis 451 (illustrated in Fig. 5). In addition, the rotary nozzle unit 45 has a Z-axis driving mechanism 453 for driving to lift and lower the suction nozzle 46 disposed at a specific rotational position in the Z-axis direction. Further, a portion of a negative pressure supply mechanism 454 for supplying a negative pressure to the suction nozzle 46 is built in the rotary nozzle unit 45. Strictly, the negative pressure supply mechanism 454 also has a function of supplying a slight positive pressure when the suction nozzle 46 mounts the component. The R-axis rotation driving mechanism 452, the Z-axis driving mechanism 453, and the negative pressure supply mechanism 454 can be configured by appropriately applying known techniques.

First, the suction nozzle 46 is driven to an upper position of the supply position 34 by the head driving mechanism 49 and the R-axis rotation driving mechanism 452. Next, the suction nozzle 46 is driven downward by the Z-axis driving mechanism 453 to approach the supply position 34 and a negative pressure is supplied from the negative pressure supply mechanism 454 to suction the component.

As illustrated in Fig. 3, the camera device 7 is provided on the mounting head 44 and is shared by multiple feeder devices 31. The camera device 7 is disposed so that an imaging section 70 faces downward. A first to a third total reflection mirrors 71, 72, and 73 are used to form a first light path 7L1 that connects the imaging section 70 and the component confirmation hole 37 of the feeder device 31 to each other. A fourth total reflection mirror 74 is used to form the second light path 7L2 that connects the imaging section 70 and the vicinity of the distal end of the suction nozzle 46 that is lifted after suctioning the components. Fig. 4 is a side sectional view illustrating the cross-section of the feeder device 31 and the mounting head 44 and the first light path 7L1 and the second light path 7L2 of the camera device 7. In Fig. 4 to Fig. 9, Fig. 12, and Fig. 13, the component P is illustrated in black for convenience.

As illustrated in Fig. 3 and Fig. 4, the first to the fourth total reflection mirrors 71 to 74 are formed in a triangular pillar shape having a right-angled isosceles triangle as a bottom face. The first to the fourth total reflection mirrors 71 to 74 are fixed to the mounting head 44 by using an attachment member (not illustrated) not blocking the light paths 7L1 and 7L2. The first to the fourth total reflection mirrors 71 to 74 respectively reflect the light paths 7L1 and 7L2 by 90°.

Specifically, the first total reflection mirror 71 is disposed immediately below the imaging section 70 and the second total reflection mirror 72 is disposed in front of the first total reflection mirror 71. In addition, the third total reflection mirror 73 is located immediately above the component confirmation hole 37 of the feeder device 31 and is disposed on the side of the second total reflection mirror 72. The first total reflection mirror 71 reflects the first light path 7L1 facing downward from the imaging section 70 in the Y-axis direction. Subsequently, the second total reflection mirror 72 reflects the first light path 7L1 in the Y-axis direction in the X-axis direction. Finally, the third total reflection mirror 73 reflects the first light path 7L1 downward in the X-axis direction to reach the component confirmation hole 37.

On the other hand, the fourth total reflection mirror 74 is located immediately below the imaging section 70 and is disposed obliquely downward near the side of the first total reflection mirror 71. The fourth total reflection mirror 74 reflects the second light path 7L2 facing downward from the imaging section 70 in the Y-axis direction and reaches the vicinity of the distal end of the suction nozzle 46. The light path lengths of the first light path 7L1 and the second light path 7L2 are configured to be equal to each other.

Here, the component confirmation hole 37 is set at a position where the cavity section 93 immediately stops each time the carrier tape 9 is fed by a fixed pitch. As illustrated in Fig. 4, the cavity section 93E that is seen from the component confirmation hole 37 is formed on the tail end side of the carrier tape 9 by 14 cavity sections as compared with the cavity section 93F at the supply position 34. Therefore, the cavity section 93E seen from the component confirmation hole 37 corresponds to the tail end side cavity section 93E of the invention, and the small number is only 14. In addition, the first light path 7L1 passes through the component confirmation hole 37 and reaches the tail end side cavity section 93E through the transparent cover tape 92.

On the other hand, the vicinity of the tail end side cavity section 93E and the distal end of the suction nozzle 46, which is the imaging target, is irradiated by an imaging lighting tool (not illustrated). The installation position of the imaging lighting tool is not limited and the imaging lighting tool may be a separate body from the camera device 7. Further, at least one half-silvered mirror is used instead of the four first to fourth total reflection mirrors 71 to 74 and one light path from the imaging section 70 is configured to be branched to the first light path 7L1 and the second light path 7L2.

In conjunction with the suction nozzle 46 being driven to the supply position 34 of a certain feeder device 31, the camera device 7 moves to the positions illustrated in Fig. 3 and Fig. 4. Accordingly, the camera device 7 faces the tail end side cavity section 93E via the first light path 7L1 and faces the vicinity of the distal end of the suction nozzle 46 via the second light path 7L2. The camera device 7 can simultaneously image the tail end side cavity section 93E and the vicinity of the distal end of the suction nozzle 46 to obtain one piece of image data. Alternatively, the camera device 7 can separately image the vicinity of the tail end side cavity section 93E and the distal end of the suction nozzle 46 to obtain image data, respectively.

The camera device 7 images the tail end side cavity section 93E and performs an image processing on the obtained image data so that the camera device can detect whether or not the component P is held in the tail end side cavity section 93E. In addition, the camera device 7 can determine success or failure of suction of the component P and confirmation of the suction posture of the suctioned component by imaging the vicinity of the distal end of the suction nozzle 46 from the side. Therefore, imaging from a side by the camera device 7 and imaging from below by the component camera 5 are used together and thus the suction state of the component P is confirmed with high accuracy.

### (3. Operation and action of component mounting machine 1 of first embodiment)

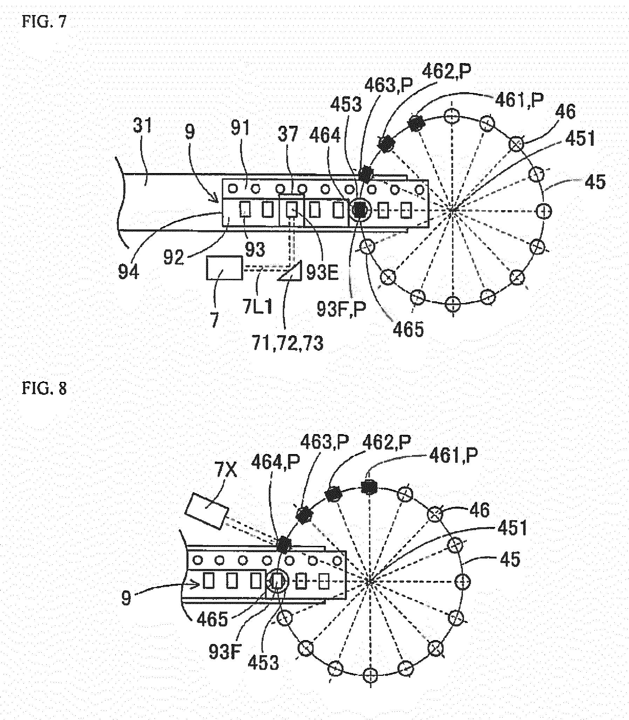

Next, the operation of the component mounting machine 1 of the first embodiment will be described schematically together with the functions of the invalid suction avoidance section and the component shortage coping section of the control device 6. Fig. 5 is a plan view schematically explaining the operation of the component mounting machine 1 according to the first embodiment. Fig. 6 is a plan view illustrating a state where one component P is suctioned from the state of Fig. 5 and the remaining number of components P is reduced to a predetermined small number. Further, Fig. 7 is a plan view illustrating a state where the suction nozzle 46 is suctioning the last component P after two components P are suctioned from s state of Fig. 6.

In order to simplify the schematic explanation, in Fig. 5 to Fig. 7, the small number is set to three. In other words, the component confirmation hole 37 of the feeder device 31 is provided on the side closer to the tail end 94 of the carrier tape 9 than the supply position 34 by three the cavity sections 93. The component is not held in the cavity section 93 up to the fifth cavity section counting from the tail end 94 of the carrier tape 9 and the last component P is held in the sixth cavity section 93 counting from the tail end 94. Assume that the use of the carrier tape 9 advances and the remaining number of components P is four.

On the other hand, the rotary nozzle unit 45 holds sixteen suction nozzles 46 of the same shape at a fixed angle pitch on a circumference thereof. In the suction nozzle 46, first to sixteenth order are set in a counterclockwise direction. The R-axis rotation driving mechanism 452 of the rotary nozzle unit 45 rotationally drives the sixteen suction nozzles 46 in a clockwise direction by a fixed angle pitch and sequentially engages the Z-axis driving mechanism 453 from the first suction nozzle 461. Here, an operation is assumed in which the total of 16 components P are suctioned by using each suction nozzle 46 and are mounted on the board K collectively.

First, under the above-assumed conditions, the rotary nozzle unit 45 is driven above the feeder device 31 and the Z-axis driving mechanism 453 is positioned immediately above the supply position 34. Next, the first suction nozzle 461 is engaged with the Z-axis driving mechanism 453 and thus the state illustrated in Fig. 5 is obtained. At this time, the camera device 7 images the tail end side cavity section 93E through the component confirmation hole 37. In the camera device 7, since the component P is held in the tail end side cavity section 93E, it is determined that the number of remaining components P is greater than three.

First, in the suction operation, the first suction nozzle 461 is driven by the Z-axis driving mechanism 453 and is lowered. Second, a negative pressure is supplied from the negative pressure supply mechanism 454 to the first suction nozzle 461 to suction the component P. Third, the first suction nozzle 461 is driven by the Z-axis driving mechanism 453 and is lifted. Fourth, the suction posture where the first suction nozzle 461 suctions the component P is imaged from the side by the camera device 7. Thereafter, the suction nozzle 46 is changed and the first to fourth operations described above are repeated. In the following description, the four operations described above are collectively referred to as "the suction nozzle 46 performs the suction operation".

After the first suction nozzle 461 performs the suction operation, the R-axis rotation driving mechanism 452 rotationally drives each suction nozzle 46 clockwise by a fixed angle pitch. Accordingly, the second suction nozzle 462 is engaged with the Z-axis driving mechanism 453. On the other hand, the carrier tape 9 is fed by a fixed pitch and the tail end side cavity section 93E moves toward the side of the tail end 94 by one carrier tape. With this, a state illustrated in Fig. 6 is obtained. At this time, the camera device 7 images the new tail end side cavity section 93E through the component confirmation hole 37. Since the component P is not held in the new tail end side cavity section 93E, the camera device 7 detects that the remaining number of the component P reaches three that is the small number and notifies the control device 6.

The control device 6 manages the remaining number of components P by exercising the function of the invalid suction avoidance section from the point of accepting notices of a small number. In other words, when the second suction nozzle 462 performs the suction operation, the control device 6 reduces the remaining number of components P from three that is the small number to two. Further, the suction nozzles 46 are rotationally driven clockwise by a fixed angle pitch and the third suction nozzles 463 are engaged with the Z-axis driving mechanism 453. On the other hand, the carrier tape 9 is also fed by a fixed pitch. When the third suction nozzle 463 performs the suction operation, the control device 6 reduces the remaining number of components P from two to one.

Further, the suction nozzles 46 are rotatably driven clockwise by a fixed angle pitch and the fourth suction nozzle 464 is engaged with the Z-axis driving mechanism 453. In addition, the carrier tape 9 is fed by a fixed pitch and a state illustrated in Fig. 7 is obtained. Then, when the fourth suction nozzle 464 performs the suction operation of the last component P, the control device 6 reduces the remaining number of components P from 1 to 0. In other words, the control device 6 can automatically determine the component shortage, and it can be understood that the component P is no longer supplied from this feeder device 31. Therefore, the control device 6 stops feeding the carrier tape 9 in the feeder device 31.

In addition, even if each suction nozzle 46 is driven to rotate clockwise by a fixed angle pitch and the fifth suction nozzle 465 is engaged with the Z-axis driving mechanism 453, the control device 6 can lower the fifth suction nozzle 465 and controls not to supply a negative pressure. Therefore, an invalid suction operation of the fifth suction nozzle 465 is avoided.

Next, the control device 6 functions as a component shortage coping section and searches for another feeder device 31 that feeds the carrier tape 9 holding components of the same type as the component P whose remaining number is zero. In a case where there is another preliminary feeder device 31, the control device 6 drives the fifth suction nozzle 465 to the supply position 34 of another feeder device 31 and performs the suction operation on all the remaining suction nozzles 46. Thereafter, the control device 6 controls the mounting operation of the sixteen components P by also moving the mounting head 44 from the component camera 5 above the board K. In a case where there is no another feeder device 31, the control device 6 informs the operator of the component shortage state.

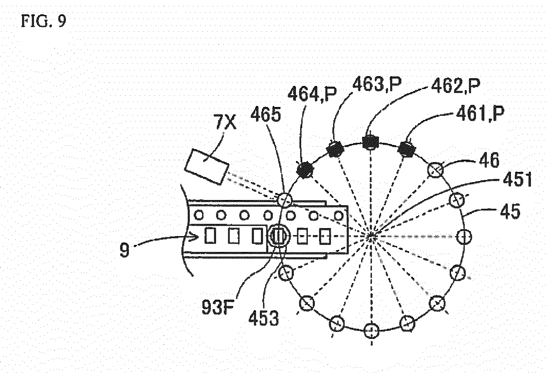

Next, the operation of the component mounting machine 1 of the first embodiment will be described in comparison with the component mounting machine of the related art. Fig. 8 is a plan view schematically explaining the configuration and operation of a component mounting machine of the related art. In addition, Fig. 9 is a plan view explaining a method of detecting that the remaining number of components has become zero in the related art. In the related art, the camera device 7X is disposed at a position to image the vicinity of the distal end of the suction nozzle 46 from the side thereof after rotating by a fixed angle pitch from the Z-axis driving mechanism 453. The presence or absence of the component P in the cavity section 93 is determined by the captured image data of the camera device 7X. Also in the related art, it is assumed that the remaining number of components P is four as in Fig. 5.

According to Fig. 8 which describes the related art, the first to fourth suction nozzles 461 to 464 suction components respectively, and the fifth suction nozzle 465 is engaged with the Z-axis driving mechanism 453. In this state, since the camera device 7X images a state where the fourth suction nozzle 464 suctions the last component P, it is not known that the remaining number of components P is zero. Therefore, the suction operation of the fifth suction nozzle 465, that is, an invalid suction operation is performed. Subsequently, the fifth suction nozzle 465 is rotationally driven, and the state illustrated in Fig. 9 is obtained.

At the time of Fig. 9, the camera device 7X images a state where the fifth suction nozzle 465 does not suction the component. Therefore, the camera device 7X determines that the remaining number of components P is zero and notifies the control device 6 of information on component shortage. Upon receipt of the information on the component shortage, the control device 6 moves the fifth suction nozzle 465 to another feeder device 31 to which the same kind of component P is supplied. At that time, the control device 6 has to rotate the fifth suction nozzle 46 in the reverse direction and engage again the fifth suction nozzle 46 with the Z-axis driving mechanism 453.

As is apparent from the comparison with the related art, in the first embodiment, invalid suction operation of the fifth suction nozzle 465, rotation of the fifth suction nozzle 465, imaging of the fifth suction nozzle 465 by the camera device 7X, and rotation of the fifth suction nozzle 46 in the reverse direction become unnecessary.

### (4. Mode and effect of component mounting machine 1 according to first embodiment)

The component mounting machine 1 of the first embodiment includes a component supply section 3 that has a feeder device 31 for feeding the carrier tape 9 formed by aligning the cavity sections 93 holding the components P in a row and sequentially supplying the components P to a predetermined supply position 34, a component transfer device 4 that has a suction nozzle 46 for suctioning the component P from the cavity section 93F at the supply position 34 and mounting the component P on the board, a mounting head 44 for holding the suction nozzle 46, and a head driving mechanism 49 for driving the mounting head 44 together with the suction nozzle 46, a camera device 7 (component fewness detecting section) which detects that the remaining number of components P held by the carrier tape 9 decreases to a predetermined small number, and a control device 6 (invalid suction avoidance section) which avoids an invalid suction operation of the suction nozzle 46 based on a detection result of the camera device 7, when the remaining number of components P held by the carrier tape 9 becomes zero.

According to the component mounting machine 1 of the first embodiment, since the camera device 7 detects that the remaining number of components P held by the carrier tape 9 decreases to a predetermined small number, it can be known exactly when the remaining number of components P becomes zero based on the detection result. When the remaining number of components P becomes zero, the control device 6 avoids the invalid suction operation of the suction nozzle 46. Therefore, since the invalid suction operation to the cavity section 93 not holding the component P is not performed and invalid suction operation and a determination process as to whether or not it is invalid are not performed, the production efficiency of the board K is improved than that of the related art.

In addition, the suction nozzle 46 does not perform an invalid suction operation for the cavity section 93 which does not hold the component P. Therefore, the suction nozzle 46 does not suction much outside air, and there is no possibility of lowering a negative pressure state of a negative pressure supply mechanism 454.

Further, the component supply section 3 has multiple feeder devices 31, and the camera device 7 is provided on the mounting head 44, is shared by multiple feeder devices 31, and faces the tail end side cavity section 93E formed on a tail end 94 side of the carrier tape 9 by only small number than the cavity section 93F at the supply position 34 in conjunction with the suction nozzle 46 being driven to the supply position 34 of any one of the multiple feeder devices 31 and detects that whether or not the component P is held on the tail end side cavity section 93E. According to this, since it is unnecessary to separately provide the camera device 7 corresponding to the component fewness detecting section in each feeder device 31, an increase in cost is reduced.

Further, the component fewness detecting section is a camera device 7 which images the tail end side cavity section 93 from above. According to this, it is possible to accurately detect whether or not the component P is held by performing an image processing on the image data obtained by imaging the tail end side cavity section 93.

Further, the camera device 7 can image the vicinity of the distal end of the suction nozzle 46 from the side and can perform at least one of determination of success or failure of suction of the component P or confirmation of suction posture of the suctioned component P. According to this, since the camera device 7 also serves as a function of imaging the vicinity of the distal end of the suction nozzle 46 from the side, in addition to the function as the component fewness detecting section, an increase in cost is reduced. In addition, since the imaging from the side by the camera device 7 and the imaging from below by the component camera 5 are used together, the suction state of the component P is confirmed with high accuracy.

Further, in the camera device 7, one or more of at least one of the total reflection mirrors 71 to 74 or the half-silvered mirror are used to form the first light path 7L1 that connects the imaging section 70 and the tail end side cavity section 93E to each other and a second light path 7L2 that connects the imaging section 70 and the vicinity of the distal end of the suction nozzle 46 to each other. According to this, since two functions described above which are also served by the camera device 7 are realized by forming the first and second light paths 7L1 and 7L2 with simple members, an increase in cost is reduced.

Further, the control device 6 performs a suction operation by driving the suction nozzle 46 to the supply position 34 of a different feeder device 31 which feeds the carrier tape 9 holding the same type of component as the component P whose remaining number is zero as the invalid suction operation of the suction nozzle 46 is avoided. According to this, even if a certain feeder device 31 becomes component shortage, it can be automatically transferred to another preliminary feeder device 31. Therefore, the production of the board K can be continued without bothering the labor of the operator.

### (5. Component mounting machine 1A of second embodiment)

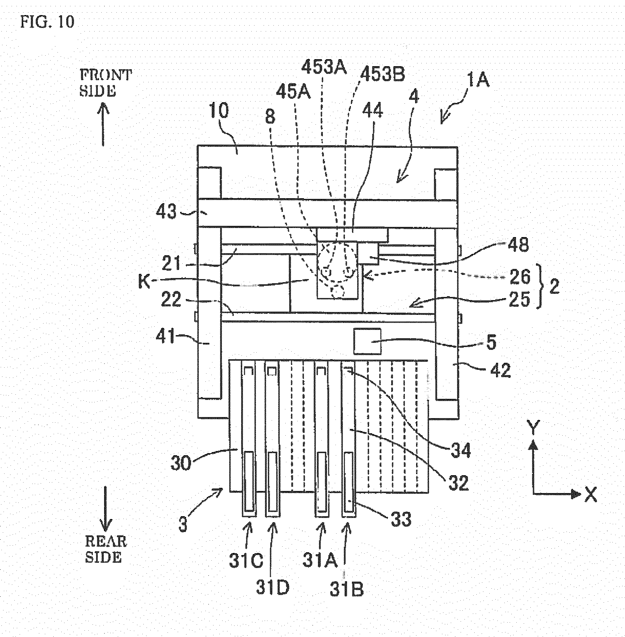

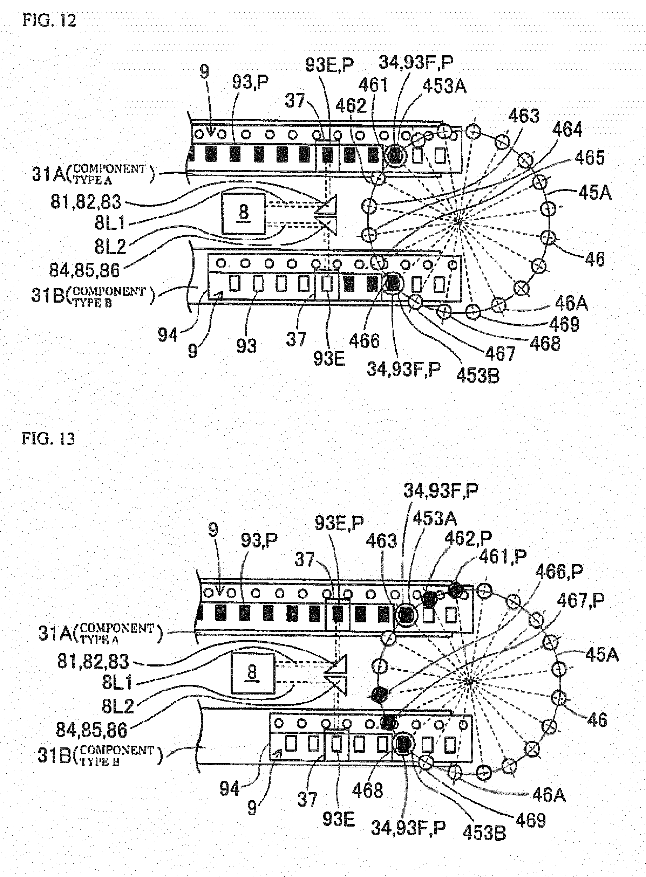

Next, with respect to the component mounting machine 1A of the second embodiment, points different from the first embodiment will be mainly described with reference to Fig. 10 to Fig. 13. Fig. 10 is a plan view schematically illustrating the configuration of the component mounting machine 1A according to the second embodiment. In the second embodiment, the rotary nozzle unit 45A holds twenty suction nozzles 46 and has two sets of Z-axis driving mechanisms 453A and 453B to simultaneously suction two components P. The first and second Z-axis driving mechanisms 453A and 453B are disposed within the rotary nozzle unit 45A to be spaced apart by 90° from each other. Therefore, two suction nozzles 46 separated from each other by five suction nozzles are engaged with the first and second Z-axis driving mechanisms 453A and 453B. For example, when the first suction nozzle 461 is engaged with the first Z-axis driving mechanism 453A, at the same time, the sixth suction nozzle 466 is engaged with the second Z-axis driving mechanism 453B (see Fig. 12).

Corresponding to the two sets of Z-axis driving mechanisms 453A and 453B, two pairs of feeder devices 31A and 31B are mounted on the pallet table 30 of the component supply section 3 with an interval therebetween. In Fig. 10, the first feeder device 31A for supplying the component P of the component type A and the second feeder device 31B for supplying the component P of the component type B are equipped with an interval corresponding to one feeder device 31. As a further preliminary, a third feeder device 31C for supplying the component P of the component type A and a fourth feeder device 31D for supplying the component P of the component type B are equipped with an interval corresponding to one feeder device 31.

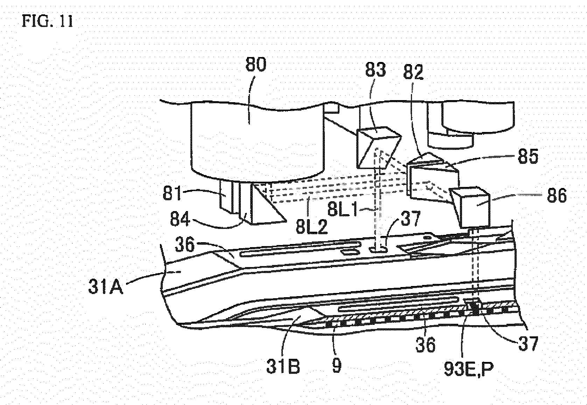

The camera device 8 is also provided in the mounting head 44 in the second embodiment and is installed so that the imaging section 80 faces downward. However, in the second embodiment, the structure related to the formation of the light paths 8L1 and 8L2 is changed. Fig. 11 is a perspective view illustrating the first light path 8L1 and the second light path 8L2 of the camera device 8 according to the second embodiment. As illustrated in the drawing, the camera device 8 operates while being disposed between the first feeder device 31A and the second feeder device 31B. The first to third total reflection mirrors 81, 82, and 83 are used to form the first light path 8L1 connecting the imaging section 80 and the component confirmation hole 37 of the first feeder device 31A to each other. In addition, fourth to sixth total reflection mirrors 84, 85, and 86 are used to form a second light path 8L2 that connects the imaging section 80 and the component confirmation hole 37 of the second feeder device 31B to each other.

As illustrated in Fig. 11, the first to sixth total reflection mirrors 81 to 86 are formed into a triangular pillar shape having a right-angled isosceles triangle as a bottom face. The first to the sixth total reflection mirrors 81 to 86 are fixed to the mounting head 44 by using an attachment member (not illustrated) not blocking the light paths 8L1 and 8L2. The first to the sixth total reflection mirrors 81 to 86 reflect the light paths 8L1 and 8L2 by 90°, respectively.

Specifically, the first total reflection mirror 81 is disposed immediately below the imaging section 80 and the second total reflection mirror 82 is disposed in front of the first total reflection mirror 81. In addition, the third total reflection mirror 83 is positioned immediately above the component confirmation hole 37 of the first feeder device 31A and is disposed on the side of the second total reflection mirror 82. The first total reflection mirror 81 reflects the first light path 8L1 facing downward from the imaging section 80 in the Y-axis direction. Subsequently, the second total reflection mirror 82 reflects the first light path 8L1 in the Y-axis direction in the X-axis direction. Finally, the third total reflection mirror 83 reflects the first light path 8L1 in the X-axis direction downward and reaches the component confirmation hole 37 of the first feeder device 31A. Accordingly, the first light path 8L1 passes through the component confirmation hole 37 of the first feeder device 31A and reaches the tail end side cavity section 93E.

On the other hand, the second light path 8L2 is mirror-symmetrical with the first light path 8L1. The fourth total reflection mirror 84 is disposed side by side with the first total reflection mirror 81 immediately below the imaging section 80 and the fifth total reflection mirror 85 is disposed in front of the fourth total reflection mirror 84. In addition, the sixth total reflection mirror 86 is located immediately above the component confirmation hole 37 of the second feeder device 31B and is disposed on the side of the fifth total reflection mirror 85. The second light path 8L2 is reflected by the fourth to sixth total reflection mirrors 84 to 86 and reaches the tail end side cavity section 93E through the component confirmation hole 37 of the second feeder device 31B.

In conjunction with the first and second Z-axis driving mechanisms 453A and 453B being driven to the supply positions 34 of the first and second feeder devices 31A and 31B, the camera device 8 moves to the position illustrated in Fig. 11. Accordingly, the camera device 8 faces the tail end side cavity section 93E of the first and second feeder devices 31A and 31B via the first light path 8L1 and the second light path. The camera device 8 can detect whether or not each of the components P is held by imaging the two locations of tail end side cavity sections 93E at the same time or separately.

Next, the operation of the component mounting machine 1A according to the second embodiment will be described schematically together with the functions of the invalid suction avoidance section and the component shortage coping section of the control device 6. Fig. 12 is a plan view schematically explaining the operation of the component mounting machine 1A according to the second embodiment. Fig. 13 is a plan view illustrating a state where the eighth suction nozzle 46 is suctioning the last component P of the component type B after two components P of the component types A and B are suctioned from a state of Fig. 12.

In order to simplify the schematic explanation, in Fig. 12 and Fig. 13, the small number is set to three. The component is not held in the cavity section 93 up to the fifth cavity section counting from the tail end 94 of the carrier tape 9 and the last component P is held in the sixth cavity section 93 counting from the tail end 94. It is assumed that the remaining number of components P of the component type A of the first feeder device 31A is large and the small number of components P of the component type B of the second feeder device 31B is set to three that is the small number.

On the other hand, with regard to the rotary nozzle unit 45A, it is assumed that an operation of suctioning five components P of component type A and five components P of component type B is performed. Specifically, the rotary nozzle unit 45A suctions five components P of component type A from the first feeder unit 31A by sequentially using the first to fifth suction nozzles 461 to 465 in order, and at the same time, suctions the five components P of component type B from the second feeder device 31B by sequentially using sixth to tenth suction nozzles 466 to 469 and 46A.

First, the rotary nozzle unit 45A is driven above the first and second feeder devices 31A and 31B below the assumed conditions described above. Next, the first suction nozzle 461 is engaged with the first Z-axis driving mechanism 453A, and at the same time the sixth suction nozzle 466 is engaged with the second Z-axis driving mechanism 453B to be a state illustrated in Fig. 12. At this time, the camera device 8 images the two locations of tail end side cavity sections 93E. With regard to the first feeder device 31A, the camera device 8 determines that the remaining number of components P is greater than 3 since the component P is held in the tail end side cavity section 93E. On the other hand, with regard to the second feeder device 31B, the camera device 8 understands that the component P is not held in the tail end side cavity section 93E. Then, since the component P is held in one before cavity section 93E at the previous imaging time, the camera device 8 detects that the remaining number of the component P reaches three that is the small number and notifies the control device 6.

The control device 6 exercises the function of the invalid suction avoidance section from the point of receiving notices of a small number and performs management of the remaining number of the component P of the component type B of the second feeder device 31B. From a state of Fig. 12, after the first and second suction nozzles 461 and 462 suction the component P of the component type A and the sixth and seventh suction nozzles 466 and 467 suction the component P of the component type B, the suction nozzle 46 is rotationally driven by a fixed angle pitch. With this, a state illustrated in Fig. 13 is obtained. At this point, the control device 6 reduces the remaining number of components P of the component type B by one.

Then, the third suction nozzle 463 engaged with the first Z-axis driving mechanism 453A performs the suction operation of the component P of the component type A, and the eighth suction nozzle 468 engaged with the second Z-axis driving mechanism 453B performs the suction operation of the last component P of the component type B. Accordingly, the control device 6 reduces the remaining number of components P of component type B from 1 to 0. In other words, the control device 6 can automatically determine that the component P of the component type B becomes component shortage, and it is understood that the component P of the component type B is no longer supplied from the second feeder device 31B. The control device 6 stops feeding the carrier tape 9 in the second feeder device 31B and controls not to lower the ninth suction nozzle 469 or supply a negative pressure. Therefore, an invalid suction operation of the ninth suction nozzle 469 is avoided.

Next, the control device 6 functions as a component shortage coping section and moves the rotary nozzle unit 45A to another pair of third and fourth feeder devices 31C and 31 D. Thereafter, the fourth and fifth suction nozzles 464 and 465 suction the component P of component type A from the third feeder device 31C and the ninth and tenth suction nozzles 469 and 46A suction the component P of the component type B from the fourth feeder device 31D.

In a case where the third feeder device 31C is not equipped as a preliminary and only the fourth feeder device 31D is equipped, the control device 6 performs different control as a component shortage coping section. In other words, continuing from Fig. 13, the control device 6 controls the fourth and fifth suction nozzles 464 and 465 so as to suction the component P of the component type A from the first feeder device 31A. Next, the control device 6 moves the rotary nozzle unit 45A to the fourth feeder device 31D and controls so that the ninth and tenth suction nozzles 469 and 46A suction the component P of the component type B from the fourth feeder device 31D. In addition, in a case where the fourth feeder device 31D is not equipped, the control device 6 notifies the operator of the component shortage state of the component P of the component type B.

In the component mounting machine 1A according to the second embodiment, the mounting head 44 holds multiple suction nozzles 461 to 469 and 46A which can simultaneously suction components from each supply position 34 of the multiple feeder devices 31A to 31D, and includes one camera device 8 (component fewness detecting section) shared by the multiple suction nozzles 461 to 469 and 46A. According to this, since the camera device 8 corresponding to the component fewness detecting section is shared, an increase in cost is reduced.

Further, one component fewness detecting section shared by the multiple suction nozzles 461 to 469 and 46A is the camera device 8 which is provided in the mounting head 44 and at the same time images each of the tail end side cavity sections 93E of the multiple feeder devices 31A to 31D to which the component is suctioned from above, when the multiple suction nozzles 461 to 469 and 46A are driven to each supply position 34, and one or more of at least one of the total reflection mirrors 81 to 86 or the half-silvered mirror are used to form a first light path 8L1 and a second light path 8L2 that connect the imaging section 80 and each tail end side cavity section 93E. According to this, since the first and second light paths 7L1 and 7L2 of the shared camera device 8 are formed by simple members, an increase in cost is reduced.

### (6. Application and modification of embodiment)

In the second embodiment, instead of the camera device 8, two camera devices 7 of the first embodiment can be used. In addition, the imaging visual field of the camera device 8 may be divided into four to image the two locations of the tail end side cavity sections 93E and the two locations of the component suction postures. Further, various modifications are conceivable for the method of forming the first light paths 7L1 and 8L1 and the second light paths 7L2 and 8L2. In addition, in the first and second embodiments, a height sensor for measuring the height of the inside section of the cavity section 93 after the cover tape 92 is peeled off can be used as detecting means instead of the camera devices 7 and 8.

Further, the invention can also be implemented in a configuration in which the mounting head 44 holds one suction nozzle 46 without using the rotary nozzle units 45 and 45A. Various other applications and modifications are possible with the present invention.

### Reference Signs List

1, 1A: component mounting machine, 2: board conveyance device, 3: component supply section, 31: feeder device, 34: supply position, 37: component confirmation hole, 4: component transfer device, 44: mounting head, 45, 45A: rotary nozzle unit, 46, 461 to 469, 46A: suction nozzle, 49: head driving mechanism, 5: component camera, 6: control device (invalid suction avoidance section, component shortage coping section), 7: camera device, 7L1: first light path, 7L2: second light path, 71 to 74: total reflection mirror, 8: camera device, 8L1: first light path, 8L2: second light path, 81 to 86: total reflection mirror, 9: carrier tape, 93: cavity section, 93F: cavity section at supply position, 93E: tail end side cavity section, K: board, P: component

## Claims

1. A component mounting machine (1, 1A) comprising:
a component supply section (3) which has a feeder device (31) for feeding carrier tapes (9) formed by cavity sections (93) for holding components (P) being aligned in a row and is configured to sequentially supply the components (P) to a predetermined supply position (34);
a component transfer device (4) which has a suction nozzle (46, 46A) configured to suck the components (P) from the cavity sections (93) at the supply position (34) and mount the component (P) on a board (K), a mounting head (44) configured to hold the suction nozzle (46, 46A), and a head driving mechanism (49) configured to drive the suction nozzle (46, 46A) and the mounting head (44);
a component fewness detecting section (7) configured to detect that a remaining number of components (P) held by the carrier tape (9) decreases to a predetermined small number; and
an invalid suction avoidance section (6) configured to avoid an invalid suction operation of the suction nozzle (46, 46A) based on a detection result of the component fewness detecting section (7) when the remaining number of components (P) held by the carrier tape (9) reaches zero, **characterized in that**
the component supply section (3) has a plurality of feeder devices (31), and
wherein the component fewness detecting section (7) is provided on the mounting head (44), is shared by a plurality of feeder devices (31), and faces a tail end side cavity section (93E) formed on a tail end side of the carrier tape (9) more by the small number than the cavity section at the supply position (93F) in conjunction with the suction nozzle (46, 46A) being driven to the supply position (34) of any one of the plurality of feeder devices (31) and is configured to detect that whether or not the component (P) is held on the tail end side cavity section (93E).

2. The component mounting machine according to claim 1,
wherein the component fewness detecting section (7) is a camera device (7) that is configured to image the tail end side cavity section (93E) from above.

3. The component mounting machine according to claim 2,
wherein the camera device (7) is configured to image the vicinity of a distal end of the suction nozzle (46, 46A) from the side and can perform at least one of determination of success or failure of suction of the component (P) or confirmation of suction posture of the sucked component (P).

4. The component mounting machine according to claim 3,
wherein one or more of at least one of the total reflection mirrors or the half-silvered mirror (71-74, 81-86) are used to form a light path (7L1, 8L1) that connects an imaging section and the tail end side cavity section (93E) to each other and a light path (7L2, 8L2) that connects the imaging section and the vicinity of the distal end of the suction nozzle (46, 46A) to each other, in the camera device (7).

5. The component mounting machine according to any one of claims 1 to 4,
wherein the mounting head (44) is configured to hold a plurality of suction nozzles (46, 46A) capable of simultaneously sucking components (P) from each supply position (34) of the plurality of feeder devices (31), and
wherein one component fewness detecting section (7) shared by the plurality of suction nozzles (46, 46A) or a plurality of the component fewness detecting sections (7) corresponding to the plurality of suction nozzles (46, 46A) individually are provided.

6. The component mounting machine according to claim 5,
wherein one component fewness detecting section (7) shared by the plurality of suction nozzles (46, 46A) is a camera device (7) which is provided in the mounting head (44) and is configured to image each of the tail end side cavity sections (93E) of the plurality of feeder devices (31) to which the component (P) is sucked from above at the same time, when the plurality of suction nozzles (46, 46A) are driven to each supply position (34), and
wherein one or more of at least one of the total reflection mirrors or the half-silvered mirror (71-74, 81-86) are used to form a plurality of light paths (7L1, 8L1) that connect the imaging section and each tail end side cavity section (93E) to each other.

7. The component mounting machine according to any one claims 1 to 6, further comprising:
a component shortage coping section (6) that is configured to perform a suction operation by driving the suction nozzle (46, 46A) to a supplying position (34) of a different feeder device (31) which feeds a carrier tape (9) holding the same type of component (P) as the component whose remaining number is zero as the invalid suction avoidance section (6) avoids the invalid suction operation of the suction nozzle (46, 46A).

## Patentansprüche

1. Maschine (1, 1A) zum Montieren von Bauteilen, die umfasst:
einen Bauteil-Zuführabschnitt (3), der eine Zuführvorrichtung (31) zum Zuführen von Trägerbändern (9) aufweist, die durch Hohlraum-Abschnitte (93) zum Aufnehmen von Bauteilen (P) gebildet werden, die in einer Reihe ausgerichtet sind, und der so ausgeführt ist, dass er die Bauteile (P) sequentiell einer vorgegebenen Zuführposition (34) zuführt;
eine Bauteil-Überführungsvorrichtung (4), die eine Saugdüse (46, 46A), die so ausgeführt ist, dass sie die Bauteile (P) aus den Hohlraum-Abschnitten (93) an der Zuführposition (34) ansaugt und das Bauteil (P) auf einer Platine (K) montiert, einen Montage-Kopf (44), der so ausgeführt ist, dass er die Saugdüse (46, 46A) hält, sowie einen Kopf-Antriebsmechanismus (49) aufweist, der so ausgeführt ist, dass er die Saugdüse (46, 46A) und den Montage-Kopf (44) antreibt;
einen Abschnitt (7) zum Erfassen einer geringen Anzahl an Bauteilen, der so ausgeführt ist, dass er erfasst, dass eine verbleibende Anzahl von dem Trägerband (9) aufgenommener Bauteile (P) auf eine vorgegebene geringe Anzahl abnimmt; und
einen Abschnitt (6) zur Vermeidung fehlerhafter Ansaugung, der so ausgeführt ist, dass er einen fehlerhaften Ansaugvorgang der Ansaugdüse (46, 46A) auf Basis eines Erfassungsergebnisses des Abschnitts (7) zum Erfassen einer geringen Anzahl an Bauteilen vermeidet, wenn die verbleibende Anzahl von dem Trägerband (9) aufgenommener Bauteile (P) Null erreicht, **dadurch gekennzeichnet, dass**
der Bauteil-Zuführabschnitt (3) eine Vielzahl von Zuführvorrichtungen (31) aufweist, und
wobei der Abschnitt (7) zum Erfassen einer geringen Anzahl an Bauteilen an dem Montage-Kopf (44) vorhanden ist, von einer Vielzahl von Zuführvorrichtungen (31) gemeinsam genutzt wird und einem Hohlraum-Abschnitt (93E) an einer Seite des hinteren Endes, der an einer Seite des hinteren Endes des Trägerbandes (9) ausgebildet ist, um die geringe Anzahl mehr zugewandt ist als der Hohlraum-Abschnitt an der Zuführposition (93F), wenn die Saugdüse (46), 46A) an die Zuführposition (34) einer der Vielzahl von Zuführvorrichtungen (31) bewegt wird, und so ausgeführt ist, dass er erfasst, ob das Bauteil (P) an dem Hohlraum-Abschnitt (93E) an einer Seite des hinteren Endes aufgenommen ist oder nicht.

2. Maschine zum Montieren von Bauteilen nach Anspruch 1,
wobei der Abschnitt (7) zum Erfassen einer geringen Anzahl an Bauteilen eine Kamera-Vorrichtung (7) ist, die so ausgeführt ist, dass sie ein Bild des Hohlraum-Abschnitts (93E) an einer Seite des hinteren Endes von oben erzeugt.

3. Maschine zum Montieren von Bauteilen nach Anspruch 2,
wobei die Kamera-Vorrichtung (7) so ausgeführt ist, dass sie ein Bild der Umgebung eines vorderen Endes der Saugdüse (46, 46A) von der Seite aus erzeugt und Erfolg oder Misserfolg beim Ansaugen des Bauteils (P) feststellen oder/und Prüfung der Ansaug-Stellung des angesaugten Bauteils (P) durchführen kann.

4. Maschine zum Montieren von Bauteilen nach Anspruch 3,
wobei einer oder mehrere von den Totalreflexionsspiegeln oder/und dem halbdurchlässigen Spiegel (71-74, 81-86) dazu dient/dienen, einen Lichtweg (7L1, 8L1), der einen Bilderzeugungs-Abschnitt und den Hohlraum-Abschnitt (93E) an einer Seite des hinteren Endes miteinander verbindet, sowie einen Lichtweg (7L2, 8L2), der den Bilderzeugungs-Abschnitt und die Umgebung des vorderen Endes der Saugdüse (46, 46A) miteinander verbindet, in der Kamera-Vorrichtung (7) auszubilden.

5. Maschine zum Montieren von Bauteilen nach einem der Ansprüche 1 bis 4,
wobei der Montage-Kopf (44) so ausgeführt ist, dass er eine Vielzahl von Saugdüsen (46, 46A) aufnimmt, die in der Lage sind, gleichzeitig Bauteile (P) von jeder Zuführposition (34) der Vielzahl von Zuführvorrichtungen (31) anzusaugen, und
wobei ein Abschnitt (7) zum Erfassen einer geringen Anzahl an Bauteilen, der von der Vielzahl von Saugdüsen (46, 46A) gemeinsam genutzt wird, oder eine Vielzahl der Abschnitte (7) zum Erfassen einer geringen Anzahl an Bauteilen vorhanden ist/sind, die der Vielzahl von Saugdüsen (46, 46A) einzeln entsprechen.

6. Maschine zum Montieren von Bauteilen nach Anspruch 5,
wobei ein Abschnitt (7) zum Erfassen einer geringen Anzahl an Bauteilen, der von der Vielzahl von Saugdüsen (46, 46A) gemeinsam genutzt wird, eine Kamera-Vorrichtung (7) ist, die in dem Montage-Kopf (44) vorhanden und so ausgeführt ist, dass sie ein Bild jedes der Hohlraum-Abschnitte (93E) an einer Seite des hinteren Endes der Vielzahl von Zuführvorrichtungen (31), an die das Bauteil (P) angesaugt wird, gleichzeitig von oben erzeugt, wenn die Vielzahl von Saugdüsen (46, 46A) zu jeder Zuführposition (34) bewegt wird, und
wobei einer oder mehrere von den Totalreflexionsspiegeln oder/und dem halbdurchlässigen Spiegel (71-74, 81-86) dazu dient/dienen, eine Vielzahl von Lichtwegen (7L1, 8L1) auszubilden, die den Bilderzeugungs-Abschnitt und jeden Hohlraumabschnitt (93E) an einer Seite des hinteren Endes miteinander verbinden.

7. Maschine zum Montieren von Bauteilen nach einem der Ansprüche 1 bis 6, die des Weiteren umfasst:
einen Abschnitt (6) zum Beheben eines Mangels an Bauteilen, der so ausgeführt ist, dass er einen Ansaugvorgang ausführt, indem er die Saugdüse (46, 46A) an eine Zuführposition (34) einer anderen Zuführvorrichtung (31) bewegt, die ein Trägerband (9) zuführt, das denselben Typ von Bauteil (P) wie das Bauteil aufnimmt, dessen verbleibende Anzahl 0 beträgt, wenn der Abschnitt (6) zur Vermeidung fehlerhafter Ansaugung den fehlerhaften Ansaugvorgang der Saugdüse (46, 46A) vermeidet.

## Revendications

1. Machine de montage de composants (1, 1A) comprenant :
une section de délivrance de composant (3) qui possède un dispositif d'alimentation (31) destiné à délivrer des bandes porteuses (9) formées de sections de cavités (93) afin de maintenir des composants (P) alignés en rangée, et qui est configuré pour délivrer séquentiellement les composants (P) à une position prédéterminée de délivrance (34),
un dispositif de transfert de composant (4) qui possède une buse d'aspiration (46, 46A) configurée pour aspirer les composants (P) des sections de cavités (93) à la position de délivrance (34) et pour monter le composant (P) sur une carte (K), une tête de montage (44) configurée pour maintenir la buse d'aspiration (46, 46A) et un mécanisme d'entraînement de tête (40) configuré pour entraîner la buse d'aspiration (46, 46A) et la tête de montage (44),
une section de détection de rareté des composants (7) configurée pour détecter que le nombre restant de composants (P) maintenus par la bande porteuse (9) diminue jusqu'à un petit nombre prédéterminé, et
une section de prévention d'aspiration invalide (6) configurée pour empêcher une opération invalide d'aspiration de la buse d'aspiration (46, 46A) sur la base d'un résultat de détection de la section de détection de rareté des composants (7) lorsque le nombre restant de composants (P) maintenus par la bande porteuse (9) atteint zéro, **caractérisé en ce que :**
la section de délivrance de composant (3) comporte une pluralité de dispositifs d'alimentation (31), et
dans laquelle la section de détection de rareté des composants (7) est disposée sur la tête de montage (44), elle est partagée par une pluralité de dispositifs d'alimentation (31) et elle fait face à une section de cavité d'extrémité de fin (93E) formée sur l'extrémité de fin de la bande porteuse (9) plus par le petit nombre que la section de cavité à la position de délivrance (93F) conjointement avec l'entraînement de la buse d'aspiration (46, 46A) vers la position de délivrance (34) de l'un quelconque de la pluralité de dispositifs d'alimentation (31), et elle est configurée pour détecter si le composant (P) est maintenu ou non sur la section de cavité d'extrémité de fin (93E).

2. Machine de montage de composants selon la revendication 1,
dans laquelle la section de détection de rareté des composants (7) est un appareil de prise de vues (7) qui est configuré pour mettre en image la section de cavité d'extrémité de fin (93E) par dessus.

3. Machine de montage de composants selon la revendication 2,
dans laquelle l'appareil de prise de vues (7) est configuré pour mettre en image le voisinage de l'extrémité distale de la buse d'aspiration (46, 46A) depuis le côté, et il peut effectuer au moins une action parmi la détermination du succès ou de l'échec de l'aspiration du composant (P) ou bien la confirmation de l'orientation d'aspiration du composant (P) aspiré.

4. Machine de montage de composants selon la revendication 3,
dans laquelle un exemplaire ou plusieurs d'au moins l'un des miroirs de réflexion totale ou du miroir semi argenté (71 à 74, 81 à 86) sont utilisés pour former un trajet lumineux (7L1, 8L1) qui relie l'une à l'autre une section de mise en image et la section de cavité d'extrémité de fin (93E), ainsi qu'un trajet lumineux (7L2, 8L2) qui relie l'une à l'autre la section de mise en image et le voisinage de l'extrémité distale de la buse d'aspiration (46, 46A), dans l'appareil de prise de vues (7).

5. Machine de montage de composants selon l'une quelconque des revendications 1 à 4,
dans laquelle la tête de montage (44) est configurée pour maintenir une pluralité de buses d'aspiration (46, 46A) pouvant aspirer simultanément des composants (P) à partir de chaque position de délivrance (34) de la pluralité de dispositifs d'alimentation (31), et
dans laquelle est prévue une section de détection de rareté des composants (7), partagée par la pluralité de buses d'aspiration (46, 46A), ou bien sont prévues individuellement une pluralité de sections de détection de rareté des composants (7) correspondant à la pluralité de buses d'aspiration (46, 46A).

6. Machine de montage de composants selon la revendication 5,
dans laquelle la section de détection de rareté des composants (7) partagée par la pluralité de buses d'aspiration (46, 46A) est un appareil de prise de vues (7) qui est disposé dans la tête de montage (44) et configuré pour mettre en image chacune des sections de cavité d'extrémité de fin (93E) de la pluralité de dispositifs d'alimentation (31) à partir desquels est aspiré le composant (P) depuis le dessus en même temps, lorsque les différentes buses d'aspiration (46, 46A) sont entraînées à chaque position de délivrance (34), et
dans laquelle un exemplaire ou plusieurs d'au moins l'un des miroirs de réflexion totale ou du miroir semi argenté (71 à 74, 81 à 86) sont utilisés pour former une pluralité de trajets lumineux (7L1, 8L1) qui relient l'une à l'autre la section de mise en image et chaque section de cavité d'extrémité de fin (93E).

7. Machine de montage de composants selon l'une quelconque des revendications 1 à 6, comprenant en outre :
une section d'adaptation à la pénurie de composants (6) qui est configurée pour effectuer une opération d'aspiration en entraînant la buse d'aspiration (46, 46A) jusqu'à une position de délivrance d'un dispositif d'alimentation (31) différent qui délivre une bande porteuse (9) maintenant le même type de composant (P) que le composant dont le nombre restant est zéro lorsque la section de prévention d'aspiration invalide (6) a évité l'opération d'aspiration invalide de la buse d'aspiration (46, 46A).
